(19) Europäisches Patentamt / European Patent Office / Office européen des brevets

(11) **EP 3 046 110 B1**

(12) **FASCICULE DE BREVET EUROPÉEN**

(45) Date de publication et mention
de la délivrance du brevet:
**04.09.2019 Bulletin 2019/36**

(51) Int Cl.:
**G11C 29/04** *(2006.01)* **G11C 29/06** *(2006.01)*
**G11C 29/12** *(2006.01)* **G11C 29/50** *(2006.01)*
**G11C 29/56** *(2006.01)*

(21) Numéro de dépôt: **16150946.8**

(22) Date de dépôt: **12.01.2016**

(54) **SYSTÈME DE CARACTÉRISATION D'UNE CELLULE MÉMOIRE FLASH**

SYSTEM ZUR CHARAKTERISIERUNG EINER FLASH-SPEICHERZELLE

SYSTEM FOR CHARACTERISING A FLASH MEMORY CELL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **15.01.2015 FR 1550306**

(43) Date de publication de la demande:
**20.07.2016 Bulletin 2016/29**

(73) Titulaire: **COMMISSARIAT À L'ÉNERGIE
ATOMIQUE ET AUX
ÉNERGIES ALTERNATIVES
75015 Paris (FR)**

(72) Inventeurs:
• **COIGNUS, Jean**
**38000 Grenoble (FR)**
• **VERNHET, Alexandre**
**38400 SAINT MARTIN D'HERES (FR)**

(74) Mandataire: **Cabinet Camus Lebkiri
25 rue de Maubeuge
75009 Paris (FR)**

(56) Documents cités:
**US-A1- 2007 047 353      US-A1- 2008 279 006
US-A1- 2012 124 273      US-A1- 2012 170 377
US-A1- 2013 061 101      US-B1- 6 510 085**

**Description**

**DOMAINE TECHNIQUE**

La présente invention a trait au domaine de la caractérisation des mémoires non volatiles à grille flottante, appelées également mémoires à piégeage de charge, et plus particulièrement aux tests d'endurance réalisés sur des mémoires flash de type NOR pour évaluer leur fiabilité.

**ÉTAT DE LA TECHNIQUE**

Une mémoire flash est classiquement formée d'une pluralité de cellules mémoire pouvant être programmées électriquement de manière individuelle, un grand nombre de cellules, appelé bloc, secteur ou page, pouvant être effacées simultanément et électriquement.

Chaque cellule de mémoire flash est pourvue d'un transistor NMOS comprenant un substrat, des régions de source et de drain formés dans le substrat, et une grille de contrôle. Un canal de conduction peut se former dans le substrat, entre les régions de source et de drain, suivant la polarisation de la grille du transistor. Ce transistor comprend en outre un site de stockage de charges électriques, appelé grille flottante, formé par exemple d'une couche de polysilicium disposée entre deux couches d'oxyde, et situé entre la grille de contrôle et le canal de conduction.

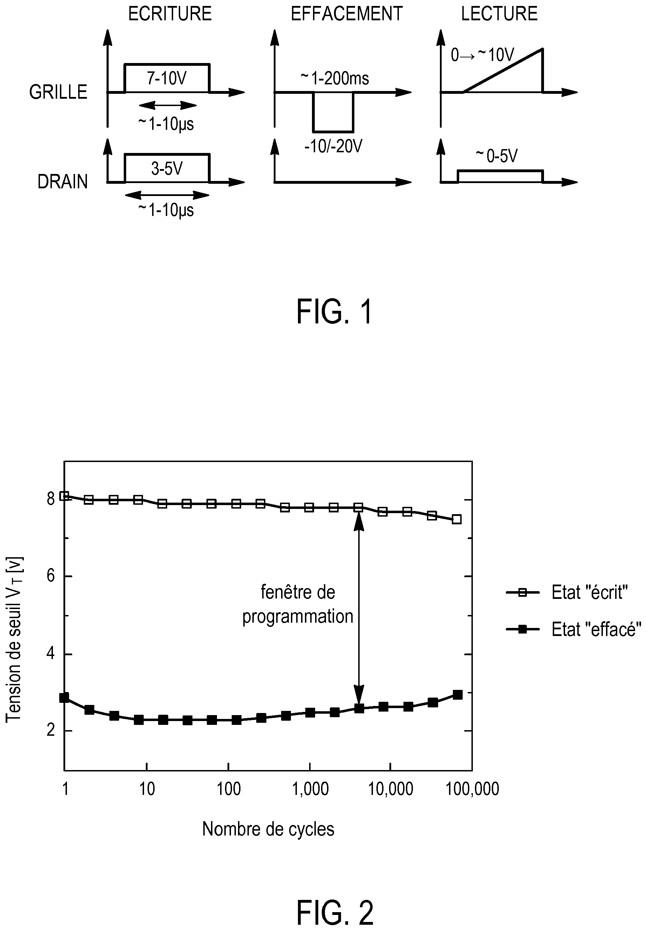

La grille de contrôle et le drain du transistor à grille flottante sont polarisés différemment selon qu'on souhaite écrire, effacer ou lire la cellule mémoire. La figure 1 est une représentation simplifiée des signaux appliqués sur la grille de contrôle et sur le drain lors des opérations d'écriture, d'effacement et de lecture d'une cellule mémoire flash de type NOR. Le substrat et la source sont connectés à la masse pour chacune de ces opérations.

La cellule mémoire peut être écrite, ou programmée, en appliquant simultanément pendant 1 $\mu$s à 10 $\mu$s une tension élevée sur la grille de contrôle, par exemple entre 7 V et 10 V, et une tension plus modérée sur le drain du transistor à grille flottante, par exemple entre 3 V et 5 V. Ces tensions permettent le passage d'électrons de très haute énergie (dit « électrons chauds ») depuis le canal de conduction vers la grille flottante. Les électrons sont alors piégés dans la grille flottante et provoquent une augmentation de la tension de seuil du transistor. La cellule mémoire passe ainsi d'un état « bas » ou « effacé », caractérisé par une faible tension de seuil (2 V-4 V), à un état « haut » ou « écrit », caractérisé par une tension de seuil élevée (6 V-9 V). Dans une cellule de mémoire flash, un bit d'information est donc codé par le niveau de la tension de seuil du transistor, typiquement '0' pour la tension de seuil basse (état effacé) et '1' pour la tension de seuil élevée (état écrit).

L'effacement de la cellule mémoire s'effectue en appliquant pendant 1 ms à 200 ms une forte tension négative sur la grille de contrôle, par exemple entre -10 V et -20 V, alors que le drain est connecté à la masse (tension nulle). Cela permet d'évacuer les électrons piégés dans la grille flottante, par effet tunnel à travers l'oxyde de grille. Ainsi, la tension de seuil du transistor est abaissée et la cellule mémoire retourne dans son état effacé.

Une méthode pour lire la cellule mémoire (i.e. pour déterminer son état : écrit ou effacé) consiste à appliquer une rampe de tension sur la grille de contrôle, par exemple de 0 V à 10 V, alors que le drain est polarisé à une tension d'environ 0,5 V, et à mesurer le courant de drain pendant cette rampe de tension. Ainsi, on obtient une caractéristique courant de drain/tension de grille permettant de déterminer la tension de seuil du transistor.

Pour évaluer la fiabilité de la cellule mémoire flash au cours de son développement technologique, une technique appelée « mesure d'endurance » consiste à faire subir à la cellule mémoire une multitude de cycles d'écriture et d'effacement dans un laps de temps très court (afin d'accélérer son vieillissement) et à suivre l'évolution des tensions de seuil de l'état écrit et de l'état effacé au cours du temps.

La figure 2 est un exemple de courbes issues de la mesure d'endurance d'une cellule de mémoire flash de type NOR (1T-NOR). Ces courbes représentent la tension de seuil $V_T$ du transistor dans l'état écrit (courbe supérieure) et la tension de seuil $V_T$ du transistor dans l'état effacé (courbe inférieure), en fonction du nombre de cycles d'écriture/effacement subis par la cellule mémoire. On observe une diminution de la tension de seuil $V_T$ de l'état écrit et une augmentation de la tension de seuil $V_T$ de l'état effacé, au fur et à mesure que le nombre de cycles d'écriture/effacement augmente. Autrement dit, la fenêtre de programmation, qui correspond à l'écart entre les deux niveaux de la tension de seuil $V_T$, se réduit au fil du temps. Lorsque cet écart diminue en dessous d'une certaine valeur, par exemple 3 V, il devient difficile de distinguer l'état écrit de l'état effacé et l'information stockée dans la cellule mémoire est perdue. Cette fermeture progressive de la fenêtre de programmation est liée à un vieillissement de l'oxyde de grille situé entre la grille flottante et le canal de conduction (piégeage de charges électriques dans l'oxyde, apparition de défauts...).

Chaque point des courbes de la figure 2 a été obtenu en effectuant une lecture de la cellule mémoire, après que celle-ci ait été écrite (pour la courbe supérieure) ou effacée (pour la courbe inférieure). La mesure d'endurance classique d'une cellule de mémoire flash consiste donc à appliquer par alternance des signaux d'écriture et d'effacement de la cellule mémoire, et à lire de temps à autre la cellule mémoire dans l'état effacé et dans l'état écrit, pour déterminer leur tension de seuil respective.

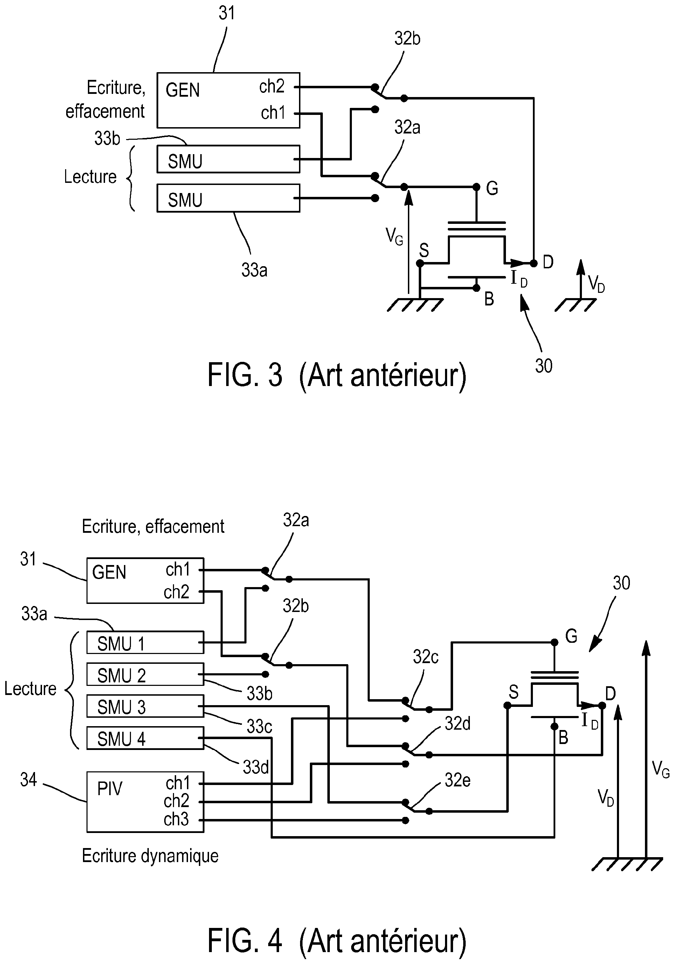

La figure 3 représente schématiquement un système de caractérisation couramment utilisé pour effectuer cette mesure d'endurance. La cellule mémoire est symbolisée par un transistor à grille flottante 30 munie de quatre électrodes : la grille G, le drain D, la source S et le substrat B (pour « Bulk » en anglais).

Le système de caractérisation comprend un générateur de tension 31 capable de fournir des tensions comprises entre +20 V et -20 V pendant une durée minimale d'une microseconde environ. Ce générateur 31 dispose d'un premier canal ch1 relié à l'électrode de grille G du transistor 30 par l'intermédiaire d'un premier commutateur électromécanique 32a et d'un deuxième canal ch2 relié à l'électrode de drain D du transistor 30 par l'intermédiaire d'un deuxième commutateur électromécanique 32b.

Le générateur 31 peut ainsi appliquer sur les électrodes G et D les impulsions requises pour écrire et effacer la cellule mémoire (amplitude maximale égale à 20 V et durée comprise entre 1 $\mu$s et 200 ms, cf. Fig.1).

En d'autres termes, le générateur de tension 31 commande les opérations d'écriture et d'effacement de la cellule mémoire. Par contre, le générateur 31 ne permet pas de lire la cellule mémoire, car il est incapable de mesurer le courant de drain $I_D$ en fonction de la tension $V_G$ appliquée sur la grille.

Les opérations de lecture sont donc réalisées au moyen de deux unités de source et mesure 33a et 33b (ou SMU, pour « Source Measure Unit » en anglais). La sortie du SMU 33a est reliée à l'électrode de grille G par l'intermédiaire du commutateur 32a, tandis que la sortie du SMU 33b est reliée à l'électrode de drain D par l'intermédiaire du commutateur 32b. Les SMU sont des instruments permettant d'appliquer une tension (respectivement un courant) et de mesurer simultanément le courant (respectivement la tension) correspondant(e). Ici, on les utilise pour appliquer simultanément une rampe de tension $V_G$ sur la grille ($V_G = 0 \rightarrow 10$ V) et une faible tension $V_D$ sur le drain ($V_D = 0,5$ V), et pour mesurer en retour le courant de drain $I_D$. On obtient alors la caractéristique $I_D(V_G)$ permettant d'extraire la tension de seuil $V_T$.

Les commutateurs 32a et 32b permettent, en basculant d'une position à l'autre, de coupler les électrodes G et D du transistor 30, soit au générateur 31 pour les opérations d'écriture et d'effacement, soit aux SMU 33a et 33b pour les opérations de lecture.

Les SMU 33a et 33b sont des dispositifs de caractérisation statique (ou DC), car ils mesurent les signaux pendant des temps longs, d'au moins plusieurs millisecondes. Par exemple, la mesure du courant de drain $I_D$ pendant la rampe de tension $V_G$ peut prendre jusqu'à plusieurs secondes avec de tels dispositifs. Or une caractérisation statique ne permet pas une mesure réaliste des propriétés de la cellule mémoire. En effet, les pièges créés par le vieillissement de l'oxyde de grille peuvent pendant la mesure capter et émettre des porteurs de charge qui modifient les propriétés électrostatiques de la cellule, provoquant ainsi une distorsion de la mesure. A l'inverse, une caractérisation dynamique, i.e. à temps court (typiquement inférieur à une milliseconde), ne laissera pas le temps aux pièges de capturer ou libérer des porteurs de charge et reflètera les propriétés intrinsèques de la cellule mémoire. Des instruments de mesure dynamique sont donc requis pour caractériser plus précisément le comportement électrique d'une cellule mémoire.

Les appareils appelés PIV (« Pulsed I-V system ») ou FMU (« Fast Measurement Unit ») ont été commercialisés dans ce but. On peut citer à titre d'exemple le modèle « Agilent B1530 ». Il permet de générer des impulsions et rampes de tension tout en mesurant dynamiquement des courants entre 1 $\mu$A et 10 mA, typiquement avec une durée d'échantillonnage de l'ordre de 10 ns. Cet outil adresse principalement des dispositifs électroniques fonctionnant sous une polarisation modérée, car l'amplitude des signaux délivrés est limitée à 10 V.

Le document [« Impact of endurance degradation on the programming efficiency and the energy consumption of NOR flash memories », V. Della Marca et al., Microelectronics Reliability, Volume 54, pp. 2262-2265, 2014] propose un système de caractérisation de cellule mémoire flash de type NOR permettant à la fois un test d'endurance (i.e. une séquence de cycles d'écriture et d'effacement), une mesure statique du courant de lecture $I_D(V_G)$ et une mesure dynamique du courant d'écriture $I_D(t)$ (où t est le temps d'écriture). Ce système de caractérisation est schématisé sur la figure 4, qui reprend la nomenclature de la figure 3.

Le système de caractérisation du document susmentionné correspond au système de caractérisation de la figure 3, auquel on a ajouté deux autres SMU 33c-33d, un appareil de mesure dynamique (PIV) 34 (Agilent B1530) et trois autres commutateurs électromécaniques à deux positions 32c, 32d et 32e. L'appareil PIV 34 comprend trois canaux ch1, ch2 et ch3 reliés respectivement aux électrodes de grille G, de drain D, et de source S du transistor à grille flottante 30. Ces liaisons s'effectuent au moyen des commutateurs 32c à 32e, car les électrodes G, D et S doivent également être reliées au générateur 31 et/ou aux SMU 33a à 33c (par l'intermédiaire des commutateurs 32a-32b en ce qui concerne les SMU 33a-33b et le générateur 31). Les sorties des SMU 33c et 33d sont reliées respectivement à l'électrode de source S (par l'intermédiaire du commutateur 32e) et au substrat B du transistor à grille flottante 30.

Ainsi, le système de caractérisation de la figure 4 comprend trois types d'instruments reliés aux électrodes du transistor à grille flottante 30 par l'intermédiaire de deux groupes de commutateurs. Ces deux groupes sont constitués par les commutateurs 32a et 32b d'une part, et par les commutateurs 32c à 32e d'autre part. Comme précédemment, le générateur 31 est chargé des opérations d'écriture et d'effacement, tandis que les SMU 33a et 33b procèdent à la lecture de la cellule mémoire (mesure $I_D(V_G)$ pour extraire la tension de seuil). Les deux SMU supplémentaires 33c et 33d servent à polariser les électrodes S et B, pour permettre d'autres mécanismes d'écriture (application d'une polarisation $V_B$ sur le substrat) ou de lecture (mesure de courant de source $I_S$ en fonction de $V_G$). Enfin, l'appareil PIV 34 permet de mesurer dynamiquement le courant de drain $I_D$ lors d'une écriture (dans le cas où l'opération d'écriture est réalisée par l'appareil PIV 34), afin notamment d'en déduire la consommation électrique de la cellule mémoire. On parle alors d'écriture « dynamique ».

Les commutateurs 32a à 32e permettent d'interrompre les cycles d'écriture et d'effacement commandés par le générateur 31, afin que les SMU 33a à 33d puissent lire la cellule mémoire ou que l'appareil PIV 34 puisse effectuer une opération d'écriture avec mesure dynamique du courant de drain $I_D$. Ils sont constitués de relais électromécaniques, afin de s'affranchir de tout courant parasite pendant la mesure du courant de drain $I_D$. En contrepartie, ce type de commutateurs présente des temps de commutation longs, de l'ordre de plusieurs millisecondes.

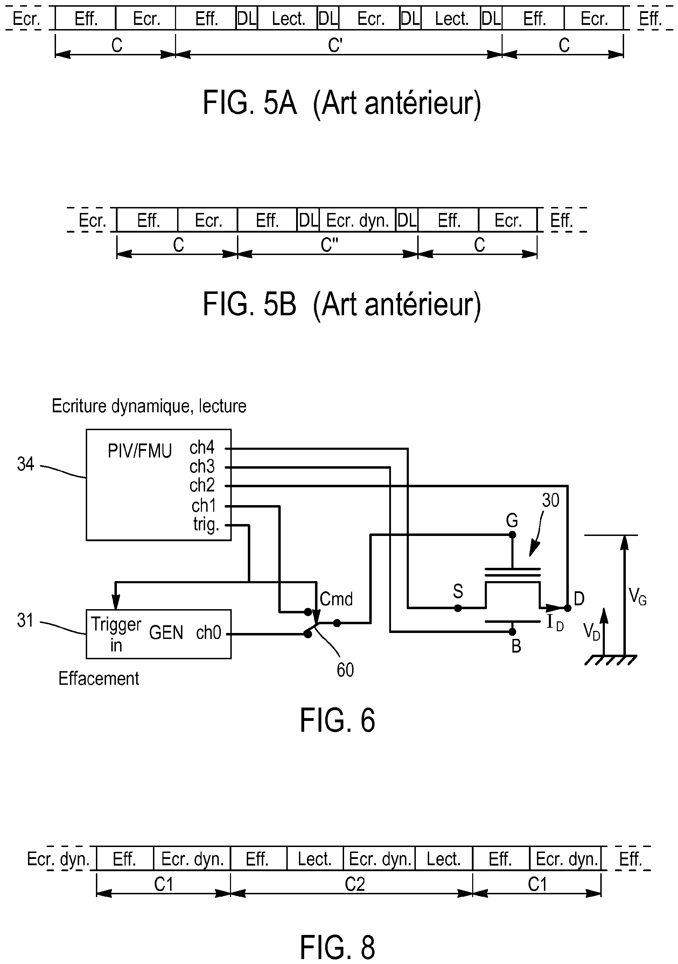

Les figures 5A et 5B illustrent une manière d'introduire les opérations de lecture ou d'écriture dynamique dans un test d'endurance, grâce au système de caractérisation de la figure 4. Les cycles notés C sont des cycles d'écriture et d'effacement classiques, réalisés au moyen du générateur 31. Entre deux de ces cycles C, on procède à un cycle d'écriture et d'effacement spécifique C' (Fig.5A) ou C'' (Fig.5B). Le cycle C' comprend une première lecture après effacement de la cellule mémoire et une seconde lecture après écriture de la cellule mémoire. On obtient ainsi deux valeurs de la tension de seuil, l'une dans l'état effacé et l'autre dans l'état écrit. Dans le cycle C'', l'opération d'écriture classique est remplacée par une opération d'écriture dynamique, afin d'avoir une mesure précise du courant de drain $I_D$ et d'en déduire l'énergie consommée par l'opération d'écriture. Les blocs « DL » situés avant et après chaque lecture dans le cycle C' (Fig.5A) ou avant et après chaque écriture dynamique dans le cycle C'' (Fig.5B) représentent le temps nécessaire pour faire basculer les commutateurs électromécaniques 32a-32b (Fig.5A) ou les commutateurs 32c à 32e (Fig.5B) d'une position à l'autre.

Les délais de basculement DL des commutateurs électromécaniques 32a à 32e ne sont pas maitrisés et peuvent fausser la caractérisation électrique. En effet, au cours de ces intervalles de temps de plusieurs millisecondes, la cellule mémoire subit une relaxation électrostatique. Il en découle que la tension de seuil mesurée lors de la lecture n'est pas représentative de l'état écrit ou effacé de la cellule mémoire, mais d'un état relaxé. Une analyse précise de la fiabilité de la cellule mémoire est alors impossible. De même, la mesure de la consommation électrique issue de l'écriture dynamique de la figure 5B ne constitue pas une information fiable du vieillissement de la cellule mémoire, également en raison de la relaxation électrostatique de la cellule mémoire lors des délais de basculement DL.

Le basculement des commutateurs électromécaniques 32a à 32e peut en outre provoquer des pics de tension susceptibles de modifier la polarisation de la cellule et donc son comportement électrique. Ces pics de tension sont par conséquent préjudiciables à l'analyse de fiabilité.

Enfin, puisque les opérations de lecture sont effectuées par les SMU, c'est-à-dire en statique, le système de caractérisation de la figure 4 présente le même défaut que le système de caractérisation de la figure 3, à savoir une distorsion potentielle de la mesure pendant la lecture.

US 2012/124273 A1 divulgue un système pour déterminer l'usure d'une mémoire flash en mesurant les nombres d'écriture et d'effacement. Afin de déterminer l'usure, ce document enseigne l'utilisation d'une machine à états pour la commande des séquences d'écriture et vérification tant que la cellule n'est pas correctement écrite.

## RÉSUMÉ DE L'INVENTION

Il existe un besoin de prévoir un système de caractérisation de l'endurance d'une cellule mémoire flash de type NOR, qui empêche la relaxation de la cellule mémoire et ne produit pas de pics de tension, afin que cette caractérisation soit la plus précise possible.

Selon l'invention, on tend à satisfaire ce besoin en prévoyant dans ce système de caractérisation :

- un générateur de tension ayant une sortie reliée à l'électrode de grille et configuré pour générer en sortie un signal d'effacement de la cellule mémoire ;
- un appareil de mesure dynamique comprenant un premier canal relié à l'électrode de grille et un deuxième canal relié à l'électrode de drain, l'appareil de mesure dynamique étant configuré pour générer sur les premier et deuxième canaux des signaux d'écriture de la cellule mémoire et pour mesurer un courant circulant dans l'électrode de drain lors de l'écriture de la cellule mémoire ;

où seule l'électrode de grille du transistor à grille flottante est reliée au générateur de tension et à l'appareil de mesure dynamique par l'intermédiaire d'un commutateur, le commutateur étant de type CMOS et capable de basculer entre une première position, dans laquelle la sortie du générateur de tension est couplée électriquement à l'électrode de grille, et une seconde position, dans laquelle le premier canal de l'appareil de mesure dynamique est couplé électriquement à l'électrode de grille, et où l'appareil de mesure dynamique est en outre configuré pour générer un signal de synchronisation transmis au générateur de tension et au commutateur pour commander simultanément la génération du signal d'effacement et le basculement du commutateur dans la première position.

Le fait que seule la liaison vers l'électrode de grille du transistor à grille flottante soit équipée d'un commutateur (ce commutateur étant de type CMOS) implique que l'électrode de drain du transistor n'est connectée à l'appareil de mesure dynamique par le biais d'aucun commutateur.

Un commutateur de type CMOS peut, à la différence d'un commutateur de type électromécanique, basculer d'une position à l'autre dans un laps de temps très court, inférieur à 1 $\mu$s. Associé au fait que le basculement de commutateur est synchronisé avec le signal d'effacement du générateur de tension, cela permet d'enchaîner quasiment sans interruption les opérations d'écriture et d'effacement, et éventuellement de lecture. La relaxation de la cellule mémoire n'a dans ce cas pas l'occasion de se produire.

Un inconvénient du commutateur de type CMOS est qu'il génère un courant de fuite dans les branches qu'il connecte. Ce courant parasite est préjudiciable pour les mesures de courant du transistor, c'est pourquoi les commutateurs électromécaniques des systèmes de caractérisation de l'art antérieur n'ont pas été remplacés par des commutateurs de type CMOS. En particulier, un commutateur de type CMOS en amont de l'électrode de drain fausserait la mesure du courant de drain, et donc la détermination de la tension de seuil et de la consommation électrique.

Ici, le seul commutateur utilisé est disposé en amont de l'électrode de grille, pour laquelle aucun courant n'est attendu en raison d'une forte impédance de l'électrode de grille. En outre, un commutateur de type CMOS ne provoque, lors de son basculement, aucun saut de tension. Il est donc parfaitement adapté pour être couplé à l'électrode de grille du transistor.

Dans un mode de mise en oeuvre préférentiel du système de caractérisation, l'appareil de mesure dynamique est en outre configuré pour générer sur les premier et deuxième canaux des signaux de lecture de la cellule mémoire et pour mesurer le courant circulant dans l'électrode de drain lors de la lecture de la cellule mémoire. On évite ainsi une distorsion de la mesure causée par l'utilisation des unités de source et mesure SMU (« Source Measure Unit »). Puisque l'appareil de mesure dynamique commande à la fois les opérations d'écriture et les opérations de lecture, un test d'endurance avec mesure dynamique du courant peut être réalisé avec seulement deux instruments. Le système de caractérisation de l'invention est donc plus simple et plus économique que le système de caractérisation de l'art antérieur proposant les mêmes fonctions.

Avantageusement, le deuxième canal de l'appareil de mesure dynamique est relié directement à l'électrode de drain du transistor à grille flottante.

L'appareil de mesure dynamique comprend avantageusement des troisième et quatrième canaux reliés respectivement à un substrat du transistor à grille flottante et à une électrode de source du transistor à grille flottante, l'appareil de mesure dynamique étant en outre configuré pour mesurer les courants du substrat et de l'électrode de source pendant les opérations d'écriture.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- la figure 1, précédemment décrite, représente les signaux appliqués aux électrodes de grille et de drain d'un transistor à grille flottante, pour écrire, effacer et lire une cellule mémoire flash de type NOR ;
- la figure 2, précédemment décrite, est un relevé de mesure d'endurance d'une cellule mémoire flash, montrant l'évolution de la tension de seuil du transistor à grille flottante dans l'état écrit et dans l'état effacé ;
- la figure 3, précédemment décrite, représente un premier système de caractérisation d'une cellule mémoire flash selon l'art antérieur ;
- la figure 4, précédemment décrite, représente un second système de caractérisation d'une cellule mémoire flash selon l'art antérieur ;
- les figures 5A et 5B, précédemment décrites, représentent deux séquences d'endurance mises en oeuvre par le système de caractérisation de la figure 4 ;
- la figure 6 représente schématiquement un système de caractérisation de cellule mémoire flash de type NOR, d'après un mode de réalisation préférentiel de l'invention ;
- les figures 7A et 7B sont des chronogrammes de signaux utilisés dans le système de caractérisation de la figure 6, pour effectuer les opérations d'écriture, d'effacement et de lecture de la cellule mémoire ;
- la figure 8 représente une mesure d'endurance optimale pouvant être mise en oeuvre grâce au système de caractérisation de la figure 6 ;
- la figure 9 est un logigramme d'un logiciel permettant de contrôler le système de caractérisation de la figure 6 ; et
- les figures 10A et 10B sont des exemples de courbes obtenues grâce au système de caractérisation de la figure 6.

Pour plus de clarté, les éléments identiques ou similaires sont repérés par des signes de références identiques sur l'ensemble des figures.

## DESCRIPTION DÉTAILLÉE D'AU MOINS UN MODE DE RÉALISATION

La figure 6 représente un mode de réalisation préférentiel d'un système de caractérisation permettant de mesurer précisément l'endurance d'une cellule mémoire « EEPROM-Flash » (communément appelée mémoire flash), de type NOR. La cellule comprend un transistor à grille flottante 30 de type NMOS pourvu de quatre électrodes : la grille de contrôle G, le drain D, la source S et le substrat B (la grille flottante et le canal de conduction ne constituent pas des électrodes de commande du transistor 30). Le stockage de l'information repose sur le piégeage de charges électriques dans la grille flottante, ce qui provoque une variation de la tension de seuil du transistor entre l'état écrit (ou programmé) et l'état effacé de la cellule mémoire.

Ce système de caractérisation comprend un appareil de mesure dynamique 34, appelé communément PIV (pour « Pulsed I(V) system » en anglais) ou FMU (« Fast Measurement Unit »), permettant de générer des tensions comprises entre -10 V et 10 V et de mesurer simultanément des courants. On peut citer à titre d'exemple le modèle FMU « B1530 » commercialisé par la société « Agilent Technology » ou le modèle PIV « 4225-RPM » commercialisé par la société « Keithley Instruments ».

L'appareil de mesure dynamique 34 est muni de deux canaux principaux ch1-ch2 et d'un canal secondaire « trig ». Le canal ch1 est relié à l'électrode de grille G du transistor à grille flottante 30, par l'intermédiaire d'un commutateur 60 de type CMOS, tandis que le canal ch2 est relié à l'électrode de drain D du transistor 30.

L'appareil 34 est configuré pour générer sur les canaux ch1-ch2 des signaux permettant d'écrire la cellule mémoire de type NOR, et plus exactement :

- sur le canal ch1 (i.e. pour polariser l'électrode de grille G), une impulsion de tension d'amplitude comprise entre 6 V et 10 V pendant une durée comprise entre 1 $\mu$s et 10 $\mu$s ; et
- sur le canal ch2 (i.e. pour polariser l'électrode de drain D), une impulsion de tension d'amplitude comprise entre 3 V et 5 V pendant une durée comprise entre 1 $\mu$s et 10 $\mu$s.

En d'autres termes, l'appareil 34 est programmé pour commander les opérations d'écriture de la cellule mémoire, en polarisant convenablement les électrodes G et D du transistor 30.

L'appareil 34 est en outre capable de mesurer dynamiquement le courant $I_D$ circulant dans l'électrode de drain D (et dans le canal ch2), appelé courant de drain ci-après, lors d'une opération d'écriture. Une mesure dynamique du courant est réalisée à une fréquence d'échantillonnage bien plus élevée qu'une mesure dite statique (ou DC). De préférence, la période de temps séparant deux échantillonnages du courant de drain $I_D$ est comprise entre 1 ns et 100 ns, par exemple 10 ns. A titre de comparaison, la période d'échantillonnage dans une mesure statique est de l'ordre de plusieurs dizaines de millisecondes. L'appareil 34 permet ainsi une mesure fidèle du courant d'écriture, d'où il découle notamment le calcul de la consommation électrique. En effet, à partir de la mesure du courant de drain $I_D$ et connaissant la tension $V_D$ appliquée sur le drain au moyen du canal ch2, il est possible de calculer l'énergie $E_C$ consommée par la cellule mémoire lors de son écriture, grâce à la relation suivante :

$$E_C = \int_{t=0}^{t=tp} V_D(t) \cdot I_D(t) \cdot \mathrm{dt} \qquad (1)$$

où « tp » est le temps d'écriture, c'est-à-dire la durée la plus courte entre les impulsions sur les électrode G et D (comprise entre 1 $\mu$s et 10 $\mu$s).

Avantageusement, l'électrode de drain D est reliée directement à l'appareil de mesure dynamique 34, c'est-à-dire qu'aucun dispositif n'est disposé entre l'électrode D et le canal ch2. Ainsi, rien ne peut perturber la mesure dynamique du courant de drain réalisée par l'appareil 34.

Le système de caractérisation de la figure 6 comprend en outre un générateur de tension 31, dont l'unique sortie utilisée « ch0 » est reliée à l'électrode de grille G du transistor 30 par l'intermédiaire du commutateur CMOS 60. Ce générateur 31 est capable de fournir en sortie ch0 des tensions comprises entre -20V et +20 V. En outre, son fonctionnement peut être contrôlé par un signal externe. A cet effet, il dispose d'une entrée de contrôle, généralement désignée « trigger in » dans les appareils du commerce. Le générateur d'impulsions et de séquences « Agilent 81110A » commercialisé par la société « Agilent Technology » est un exemple de générateur de tension pouvant être utilisé dans le système de caractérisation.

Le générateur de tension 31 est configuré pour délivrer sur la sortie ch0 un signal d'effacement de la cellule mémoire, soit une impulsion de tension d'amplitude comprise entre 10 V et 20 V pendant une durée comprise entre 1 ms et 200 ms. Cette impulsion est appliquée sur l'électrode de grille G du transistor 30, lorsque le commutateur 60 de type CMOS est dans la configuration adéquate.

Le commutateur CMOS 60 peut en effet basculer entre une première position, dans laquelle la sortie ch0 du générateur 31 est couplée électriquement à l'électrode de grille G, et une seconde position, dans laquelle le canal ch1 de l'appareil 34 est couplé électriquement à l'électrode G. Le commutateur 60 permet donc de passer d'une opération d'effacement à une opération d'écriture, et vice versa. Il comporte un ou plusieurs transistors MOSFET capable de supporter des tensions d'au moins 20 V en amplitude. Son temps de commutation est avantageusement inférieur à 100 ns. A titre d'exemple, le commutateur 60 de la figure 6 est un commutateur CMOS analogique commercialisé par la société « Maxim » sous la référence « MAX333A ».

En plus d'être rapide, le basculement du commutateur 60 entre les première et seconde positions s'effectue en synchronisme avec le fonctionnement du générateur de tension 31, grâce à un signal de synchronisation issu du canal « trig » de l'appareil 34. Ce signal de synchronisation est dirigé en entrée « trigger in » du générateur 31 d'une part, et sur une entrée de contrôle « Cmd » du commutateur CMOS 60 d'autre part. Il commande la mise en marche et la mise en veille du générateur 31, en même temps que le basculement du commutateur 60 entre les première et seconde positions.

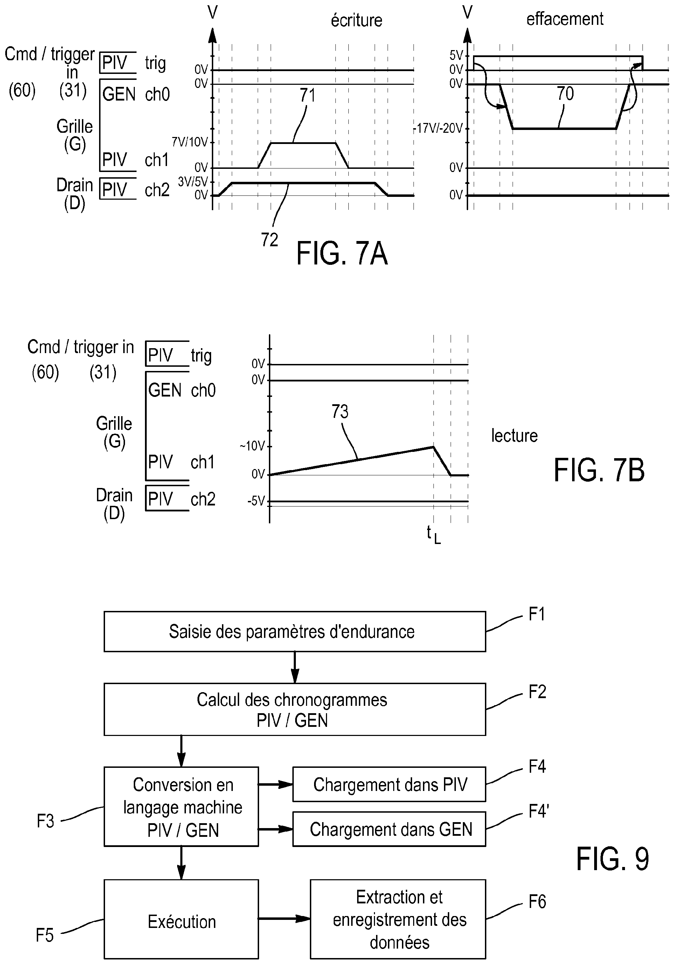

La figure 7A regroupe des chronogrammes correspondant aux signaux sur les canaux ch1-ch2 de l'appareil de mesure dynamique (PIV), du signal en sortie ch0 du générateur de tension (GEN) et du signal de synchronisation sur le canal secondaire « trig » de l'appareil de mesure dynamique. A gauche sont représentés les chronogrammes lors d'une opération d'écriture et à droite sont représentés les chronogrammes lors d'une opération d'effacement de la cellule mémoire de type NOR. Par souci de clarté, les signaux sont désignés ci-après en reprenant les références des canaux/sorties dont ils sont issus.

Les signaux ch0 et ch1 sont adressés en alternance à l'électrode de grille G, tandis que le signal ch2 est adressé à l'électrode de drain D. Le signal « trig » est envoyé simultanément à l'entrée de contrôle « Cmd » du commutateur 60 et à l'entrée « trigger in » du générateur 31.

Le signal de synchronisation « trig » devient actif (par exemple V = 5V) dès lors qu'on souhaite effacer la cellule mémoire, par exemple immédiatement après une opération d'écriture lors d'une mesure d'endurance. L'état actif du signal de synchronisation « trig » déclenche l'établissement d'une impulsion d'effacement 70 en sortie ch0 du générateur 31. Le transistor à grille flottante 30 étant de type NMOS, l'impulsion de tension 70 est négative, typiquement entre -10 V et -20 V. Simultanément, le commutateur CMOS 60 est basculé dans la première position. La sortie ch0 est alors connectée électriquement à l'électrode G afin d'y appliquer l'impulsion 70, alors que le canal ch1 est découplé de cette même électrode G. Dès lors, le signal ch1 peut être quelconque, par exemple une tension nulle comme cela est illustré sur la figure 7A. Le signal ch2, issu de l'appareil de mesure dynamique PIV et appliqué sur l'électrode de drain D, est une tension nulle pendant l'opération d'effacement. L'impulsion d'effacement 70 prend fin peu avant que le signal « trig » ne passe de l'état actif à l'état inactif (par exemple 0 V). Lorsque le signal « trig » devient inactif, le générateur 31 est mis en veille jusqu'à la prochaine activation du signal « trig », i.e. jusqu'à la prochaine opération d'effacement, et le commutateur 60 est basculé dans la seconde position, où le canal ch1 est couplé à l'électrode G (en remplacement de la sortie ch0).

L'appareil de mesure dynamique PIV prend alors le relai du générateur de tension GEN et commande à lui seul l'opération d'écriture de la cellule mémoire. Lors de cette écriture, les signaux « trig » et ch0 sont inactifs. Par contre, une impulsion 71 de courte durée et d'amplitude élevée (comprise 7-10 V) est générée par l'appareil de mesure PIV sur son canal ch1, à destination de l'électrode de grille G. En outre, une impulsion 72 de plus faible amplitude (3-5 V) est issue de son canal ch2 et transmise à l'électrode de drain D. Les impulsions 71 et 72 sont positives, car le transistor 30 est de type NMOS. De préférence, l'impulsion du drain 72 démarre avant et se termine après l'impulsion de grille 71, afin que la polarisation du drain D soit bien établie lorsqu'on applique l'impulsion 71 sur la grille G. Par conséquent, elle a une durée plus importante que l'impulsion de grille 71. A titre d'exemple, l'impulsion 72 dure 2 $\mu$s environ, alors que l'impulsion 71 ne dure que 1 $\mu$s environ.

De préférence, le canal « trigger » de l'appareil PIV est synchronisé à 5 ns près avec le premier des canaux ch1-ch2, soit le canal ch2 dans le mode de mise en oeuvre de la figure 7A. En d'autres termes, le délai entre la désactivation du signal « trigger » et l'activation du signal ch2 (effacement => écriture), ou la désactivation du signal d'écriture ch2 et l'activation du signal « trigger » (écriture => effacement), est au maximum de 5 ns.

Ainsi, contrairement aux systèmes de caractérisation de l'art antérieur, le signal de commande du commutateur, permettant la transition entre écriture et effacement, ne résulte pas d'une commande informatique. Il est ici généré par l'appareil de mesure dynamique et transmis directement au générateur de tension, ce qui garantit une excellente synchronisation entre ces deux équipements.

En plus d'une écriture dite « dynamique », qui correspond à une opération d'écriture classique couplée à une mesure dynamique du courant d'écriture, l'appareil de mesure dynamique 34 de la figure 6 peut commander une opération de lecture de la cellule mémoire. Cette lecture est accomplie sans faire usage du générateur de tension 31. Le commutateur CMOS 60 est donc placé dans sa seconde position, afin que le canal ch1 de l'appareil 34 soit couplé à l'électrode de grille G.

La figure 7B regroupe, de la même façon que la figure 7A, les chronogrammes des signaux « trig », ch0 à ch2 lors de la lecture de la cellule mémoire. Les signaux « trig » et ch0 sont inactifs (0 V). Le signal ch1 appliqué sur l'électrode de grille G est une rampe de tension 73, partant de 0 V et atteignant 10 V environ au bout d'un temps de lecture $t_L$ compris entre 10 $\mu$s et 100 $\mu$s. Pendant la rampe de tension 73, le signal ch2 polarise le drain D à une tension d'environ 0,5 V.

L'appareil 34 mesure avantageusement le courant de drain $I_D$ lors de la lecture de la cellule mémoire. Cela permet d'extraire la tension de seuil du transistor à grille flottante 30, en traçant la caractéristique courant-tension $I_D(V_G)$, $V_G$ étant la tension appliquée sur la grille G, et donc de déterminer l'état de la cellule mémoire. Comme l'opération de lecture est commandée par l'appareil 34 uniquement, elle peut être réalisée dans un temps très court (10-100 $\mu$s). On s'affranchit ainsi de toute distorsion de la mesure du courant de lecture.

La figure 8 représente un mode de mise en oeuvre préférentiel de mesure d'endurance par le système de caractérisation de la figure 6. Cette mesure d'endurance se compose de cycles C1 d'effacement et d'écriture dynamique, et de cycles C2 d'effacement et d'écriture dynamique dans lesquels on a introduit des opérations de lecture. Chaque cycle C1 permet d'établir une caractéristique de courant $I_D(t)$ du transistor à grille flottante et donc de calculer l'énergie consommée par la cellule mémoire lors de l'opération d'écriture du cycle. Un suivi de la consommation électrique au fur et à mesure des cycles C1, i.e. au cours du vieillissement de la cellule mémoire, peut donc être réalisé grâce au système de caractérisation. Chaque cycle C2 permet l'établissement d'une caractéristique courant-tension $I_D(V_G)$ et la détermination des tensions de seuil $V_T$ dans l'état effacé (lecture après effacement) et dans l'état écrit (lecture après écriture).

A la différence des systèmes de caractérisation de l'art antérieur, les différentes opérations de la mesure d'endurance peuvent s'enchaîner sans période de temps d'attente. Cela est rendu possible grâce au fait qu'on utilise un commutateur CMOS synchronisé avec le fonctionnement du générateur de tension, pour basculer entre « effacement » et « écriture dynamique » ou entre « effacement » et « lecture », et grâce au fait que la lecture est réalisée avec le même équipement que l'écriture dynamique (en ce qui concerne la transition lecture ⇔ écriture dynamique). Ainsi, il est désormais possible d'éviter la relaxation de la cellule mémoire entre deux opérations successives de la mesure d'endurance, quelles qu'elles soient ces opérations. La mesure d'endurance reflète ainsi plus fidèlement le vieillissement de la cellule mémoire.

Le système de caractérisation de la figure 6 offre la possibilité d'étudier l'impact d'une relaxation de la cellule mémoire entre les opérations d'écriture et d'effacement sur la fiabilité de la cellule mémoire. En effet, une période de temps dont la durée est contrôlée - à la différence du délai DL des figures 5A et 5B - peut être introduite volontairement entre ces deux opérations, en adaptant le signal de synchronisation de l'appareil de mesure dynamique 34.

Lors des opérations d'écriture dynamique, d'effacement et de lecture ci-dessus, l'électrode de source S et le substrat B du transistor à grille flottante 30 peuvent tous deux être connectés à la masse. En effet, la tension requise sur chacune de ces électrodes est nulle.

Cependant, dans le mode de réalisation de la figure 6, l'appareil de mesure dynamique 34 est avantageusement muni de deux autres canaux principaux ch3 et ch4, reliés respectivement à l'électrode de source S et au substrat B du transistor 30. Les canaux ch3 et ch4 permettent de polariser à une tension nulle les électrodes S et B et, simultanément, de mesurer dynamiquement les courants de la source S et du substrat B. La mesure des courants de source et/ou de substrat est d'une grande utilité pour l'étude des mécanismes d'ionisation par impact dans le canal du transistor. En effet, cette ionisation génère des paires électron-trou qui sont dissociées sous l'effet du champ électrique dans le canal, les trous étant récupérés par le substrat B. Comme l'électrode de drain D, les électrodes S et B sont de préférence reliées directement à l'appareil de mesure 34, afin que la mesure des courants ne soit perturbée par un quelconque dispositif.

De même que dans le système de caractérisation présenté en figure 4, les connexions sur le substrat et la source rendent possible l'étude d'autres mécanismes d'écriture (ex. application d'une polarisation non-nulle sur le substrat B pendant une écriture conventionnelle) ou de lecture (ex. mesure de courant de source en fonction de la tension de grille $V_G$).

Bien qu'il soit schématiquement représenté par un seul élément sur la figure 6, on comprendra aisément que l'appareil 34 peut être composé de deux modules ayant chacun deux canaux principaux, ces modules étant interconnectés pour pouvoir fonctionner simultanément.

La figure 9 est un logigramme, ou schéma d'exécution, d'un programme mis en oeuvre par ordinateur pour contrôler le système de caractérisation de la figure 6.

Ce programme affiche sur l'ordinateur une interface-utilisateur requérant, lors d'une étape F1, la saisie de paramètres par l'utilisateur. Les paramètres à saisir peuvent concerner des conditions d'écriture, d'effacement et de lecture (telles que la durée des opérations et le niveau de tension correspondant), des calibres de mesure (par exemple 1μA, 100μA, 10mA) et/ou des paramètres d'endurance (nombres de cycles d'écriture/effacement, nombre et position des opérations de lecture, délais éventuels entre les opérations d'écriture et d'effacement...).

Une fois les paramètres renseignés, l'ordinateur calcule lors d'une étape F2 les chronogrammes des signaux de l'appareil de mesure dynamique PIV et du générateur de tension GEN, a minima les chronogrammes des signaux ch0, ch1, ch2 et « trig » (cf. Fig.7A-7B).

Ces chronogrammes sont ensuite convertis en instructions exécutables par l'appareil de mesure dynamique et par le générateur de tension, lors d'une étape F3. Ces instructions définissent la configuration des deux équipements nécessaire pour mener à bien la mesure d'endurance souhaitée par l'utilisateur.

Puis, en F4 et F4', cette configuration est chargée dans chaque équipement, l'appareil de mesure dynamique PIV et le générateur de tension GEN respectivement.

Lors d'une étape F5, l'ordinateur déclenche l'exécution des instructions stockées dans l'appareil PIV. Cela a pour effet d'initier la mesure d'endurance. Le générateur de tension GEN n'est pas piloté par l'ordinateur lors de la mesure d'endurance, mais par l'appareil PIV grâce au signal de synchronisation. Une fois la séquence de cycles initiée, la mesure d'endurance est conduite par l'appareil PIV uniquement et le système de caractérisation est autonome.

Dès que la mesure d'endurance est terminée, des données sont extraites de l'appareil PIV par l'ordinateur et affichées à l'utilisateur, lors d'une étape F6. De préférence, ces données comprennent :

- un ensemble de caractéristiques de courant $I_D(t)$, chaque caractéristique $I_D(t)$ correspondant au relevé du courant de drain pendant une opération d'écriture, après un nombre variable de cycles d'écriture/effacement ;
- et avantageusement, un ensemble de caractéristiques $I_D(V_G)$, chaque caractéristique $I_D(V_G)$ correspondant à une opération de lecture pendant laquelle le courant de drain $I_D$ est mesuré en fonction de la tension $V_G$.

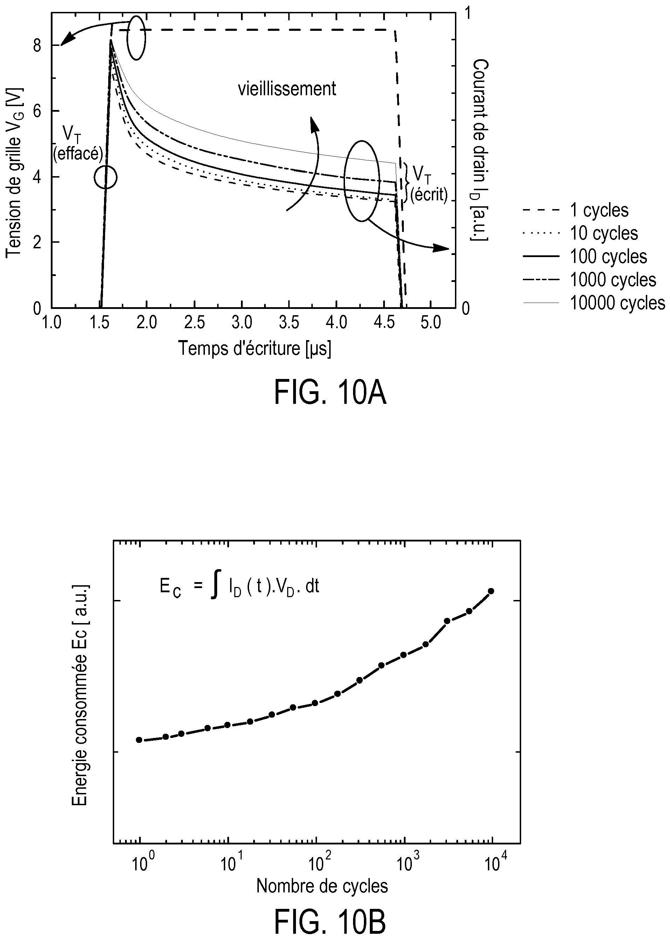

La figure 10A est un graphique montrant une pluralité de caractéristiques de courant $I_D(t)$. Cinq caractéristiques sont représentées, après respectivement 1, 10, 100, 1000 et 10000 cycles d'écriture et d'effacement. Le courant de drain $I_D$ (représenté sur l'échelle des ordonnées de droite) est exprimé en valeur relative, de 0 à 1 (sans unité). Le temps d'écriture (en abscisses) est le même pour tous les cycles. Par ailleurs, on a superposé à ces caractéristiques $I_D(t)$ la tension $V_G$ appliquée sur la grille lors des opérations d'écriture (échelle des ordonnées de gauche). L'impulsion de tension $V_G$ a une durée d'environ 3 μs.

On constate sur ce graphique l'augmentation du courant de drain $I_D$ au fur et à mesure que le nombre de cycles d'écriture et d'effacement augmente, ce qui est représentatif du vieillissement de la cellule mémoire.

Chaque caractéristique $I_D(t)$ permet de déterminer l'énergie Ec consommée par la cellule lors d'une opération d'écriture, en calculant (cf. relation (1) ci-dessus) l'intégrale du courant $I_D(t)$ multiplié par la tension $V_D$ (celle-ci étant constante pendant l'opération d'écriture). On peut ainsi suivre l'évolution de la consommation électrique de la cellule mémoire tout au long de son vieillissement. Le graphe de la figure 10B est un exemple de relevé montrant que cette énergie consommée $E_C$ augmente au fil des cycles d'écriture et d'effacement.

Les caractéristiques $I_D(t)$ permettent en outre de suivre l'évolution de la tension de seuil $V_T(t)$ au cours de l'opération d'écriture, de l'état effacé à t≈1,5 μs jusqu'à l'état écrit à t≈4,5 μs. Les valeurs de tension de seuil du transistor dans l'état effacé et dans l'état écrit peuvent être calculées à partir des valeurs du courant de drain (respectivement à t≈1,5 μs et t≈4,5 μs).

Il n'est donc pas obligatoire de relever la caractéristique $I_D(V_G)$, et donc de procéder à des lectures de la cellule mémoire, pour suivre l'évolution des tensions de seuil du transistor à grille flottante. La mesure d'endurance pourrait par conséquent se composer uniquement de cycles C1 d'écriture dynamique et d'effacement.

Il reste néanmoins avantageux de réaliser des opérations de lecture de la cellule mémoire car elles renseignent l'utilisateur sur d'autres paramètres que la tension de seuil, notamment la mobilité des porteurs de charge et les concentrations de pièges dans l'oxyde de grille et à l'interface entre l'oxyde de grille et le substrat. En effet, ces différents paramètres peuvent êtres extraits des caractéristiques $I_D(V_G)$.

## Revendications

1.    Système de caractérisation d'une cellule mémoire flash de type NOR munie d'un transistor à grille flottante (30), le transistor à grille flottante comportant une électrode de grille (G) et une électrode de drain (D), le système de caractérisation comprenant :

    - un générateur de tension (31) ayant une sortie (ch0) reliée à l'électrode de grille (G) et configuré pour générer en sortie un signal d'effacement de la cellule mémoire ; et
    - un appareil de mesure dynamique (34) comprenant un premier canal (ch1) relié à l'électrode de grille (G) et un deuxième canal (ch2) relié à l'électrode de drain (D), l'appareil de mesure dynamique (34) étant configuré pour générer sur les premier et deuxième canaux (ch1, ch2) des signaux d'écriture de la cellule mémoire et pour mesurer un courant ($I_D$) circulant dans l'électrode de drain (D) lors de l'écriture de la cellule mémoire ;

    système **caractérisé en ce que** seule l'électrode de grille (G) du transistor à grille flottante (30) est reliée au générateur de tension (31) et à l'appareil de mesure dynamique (34) par l'intermédiaire d'un commutateur (60), le commutateur étant de type CMOS et capable de basculer entre une première position, dans laquelle la sortie (ch0) du générateur de tension (31) est couplée électriquement à l'électrode de grille (G), et une seconde position, dans laquelle le premier canal (ch1) de l'appareil de mesure (34) est couplé électriquement à l'électrode de grille (G), et **en ce que** l'appareil de mesure dynamique (34) est en outre configuré pour générer un signal de synchronisation (trig) transmis au générateur de tension (31) et au commutateur (60) pour commander simultanément la génération du signal d'effacement et le basculement du commutateur dans la première position.

2.    Système selon la revendication 1, dans lequel l'appareil de mesure dynamique (34) est en outre configuré pour générer sur les premier et deuxième canaux (ch1, ch2) des signaux de lecture ($V_G$, $V_D$) de la cellule mémoire et pour mesurer le courant ($I_D$) circulant dans l'électrode de drain (D) lors de la lecture de la cellule mémoire.

3.    Système selon l'une des revendications 1 et 2, dans lequel le deuxième canal (ch2) de l'appareil de mesure dynamique (34) est relié directement à l'électrode de drain (D) du transistor à grille flottante (30).

4. Système selon l'une quelconque des revendications 1 à 3, dans lequel l'appareil de mesure dynamique (34) comprend en outre des troisième et quatrième canaux (ch3, ch4) reliés respectivement à un substrat (B) du transistor à grille flottante (30) et à une électrode de source (S) du transistor à grille flottante (30), l'appareil de mesure dynamique (34) étant en outre configuré pour mesurer des courants dans le substrat et dans l'électrode de source (S).

**Patentansprüche**

1. Charakterisierungssystem einer Flash-Speicherzelle vom Typ NOR, die mit einem Transistor mit schwebendem Gitter (30) versehen ist, wobei der Transistor mit schwebendem Gitter eine Gitterelektrode (G) und eine Dränelektrode (D) umfasst, wobei das Charakterisierungssystem umfasst:

    - einen Spannungserzeuger (31) mit einem Ausgang (ch0), der mit der Gitterelektrode (G) verbunden ist, und der konfiguriert ist, um am Ausgang ein Löschsignal der Speicherzelle zu erzeugen; und
    - ein dynamisches Messgerät (34), umfassend einen ersten Kanal (ch1), der mit der Gitterelektrode (G) verbunden ist, und einen zweiten Kanal (ch2) der mit der Dränelektrode (D) verbunden ist, wobei das dynamische Messgerät (34) konfiguriert ist, um auf dem ersten und zweiten Kanal (ch1, ch2) Schreibsignale der Speicherzelle zu erzeugen und um einen Strom ($I_D$) zu messen, der in der Dränelektrode (D) beim Schreiben der Speicherzelle fließt;

    wobei das System **dadurch gekennzeichnet ist, dass** nur die Gitterelektrode (G) des Transistors mit schwebendem Gitter (30) an dem Spannungserzeuger (31) und an dem dynamische Messgerät (34) mittels eines Schalters (60) verbunden ist, wobei der Schalter vom Typ CMOS ist und geeignet ist, zwischen einer ersten Position, in der der Ausgang (ch0) des Spannungserzeugers (31) elektrisch an die Gitterelektrode (G) angeschlossen ist, und einer zweiten Position, in der der erste Kanal (ch1) des Messgeräts (34) elektrisch an die Gitterelektrode (G) gekoppelt ist, hin- und herzuschalten, dass das dynamische Messgerät (34) darüber hinaus konfiguriert ist, um ein Synchronisationssignal (trig) zu erzeugen, das an den Spannungserzeuger (31) und den Schalter (60) übertragen wird, um gleichzeitig das Erzeugen des Löschsignals und das Umschalten des Schalters in die erste Position zu erzeugen.

2. System gemäß Anspruch 1, bei dem das dynamische Messgerät (34) darüber hinaus konfiguriert ist, um auf dem ersten und zweiten Kanal (ch1, ch2) Lesesignale ($V_G$, $V_D$) der Speicherzelle zu erzeugen und um den Strom ($I_D$) zu messen, der in der Dränelektrode (D) beim Lesen der Speicherzelle fließt.

3. System gemäß einem der Ansprüche 1 und 2, bei dem der zweite Kanal (ch2) des dynamischen Messgeräts (34) direkt mit der Dränelektrode (D) des Transistors mit schwebendem Gitter (30) verbunden ist.

4. System gemäß irgendeinem der Ansprüche 1 bis 3, bei dem das dynamische Messgerät (34) darüber hinaus dritte und vierte Kanäle (ch3, ch4) umfasst, die jeweils mit einem Substrat (B) des Transistors mit schwebendem Gitter (30) und einer Quellelektrode (S) des Transistors mit schwebendem Gitter (30) verbunden sind, wobei das dynamische Messgerät (34) darüber hinaus konfiguriert ist, um Ströme in dem Substrat und in der Quellelektrode (S) zu messen.

**Claims**

1. System for characterising a NOR-type flash memory cell provided with a floating gate transistor (30), the floating gate transistor comprising a gate electrode (G) and a drain electrode (D), the characterisation system comprising:

    - a voltage generator (31) having an output (ch0) connected to the gate electrode (G) and configured to generate as output an erase signal of the memory cell ; and
    - a dynamic measurement apparatus (34) comprising a first channel (ch1) connected to the gate electrode (G) and a second channel (ch2) connected to the drain electrode (D), the dynamic measurement apparatus (34) being configured to generate on the first and second channels (ch1, ch2) write signals of the memory cell and to measure a current ($I_D$) flowing in the drain electrode (D) during the writing of the memory cell;

    system **characterised in that** only the gate electrode (G) of the floating gate transistor (30) is connected to the voltage generator (31) and to the dynamic measurement apparatus (34) by the intermediary of a switch (60), the switch being of the CMOS type and able to switch between a first position, in which the output (ch0) of the voltage generator (31) is electrically coupled to the gate electrode (G), and a second position, in which the first channel (ch1) of the dynamic measurement apparatus (34) is electrically coupled to the gate electrode (G), and **in that** the dynamic measurement apparatus (34) is further configured to generate a synchronisation signal (trig) transmitted to the voltage generator (31) and to the switch (60) in order to simultaneously control the generation of the erase signal and the switching of the switch to the first position.

2. System according to claim 1, wherein the dynamic measurement apparatus (34) is further configured to generate on the first and second channels (ch1, ch2) read signals ($V_G$, $V_D$) of the memory cell and to measure the current ($I_D$) flowing in the drain electrode (D) during the read of the memory cell.

3. System according to one of claims 1 and 2, wherein the second channel (ch2) of the dynamic measurement apparatus (34) is connected directly to the drain electrode (D) of the floating gate transistor (30).

4. System according to any of claims 1 to 3, wherein the dynamic measurement apparatus (34) further comprises third and fourth channels (ch3, ch4) connected respectively to a substrate (B) of the floating gate transistor (30) and to a source electrode (S) of the floating gate transistor (30), the dynamic measurement apparatus (34) being further configured to measure currents in the substrate and in the source electrode (S).

**FIG. 1**

**FIG. 2**

FIG. 3 (Art antérieur)

FIG. 4 (Art antérieur)

| Ecr. | Eff. | Ecr. | Eff. | DL | Lect. | DL | Ecr. | DL | Lect. | DL | Eff. | Ecr. | Eff. |
|------|------|------|------|----|-------|----|----|----|-------|----|------|------|------|

C ← → C' ← → C

## FIG. 5A (Art antérieur)

| Ecr. | Eff. | Ecr. | Eff. | DL | Ecr. dyn. | DL | Eff. | Ecr. | Eff. |
|------|------|------|------|----|-----------|----|------|------|------|

C ← → C'' ← → C

## FIG. 5B (Art antérieur)

Ecriture dynamique, lecture

Effacement

## FIG. 6

| Ecr. dyn. | Eff. | Ecr. dyn. | Eff. | Lect. | Ecr. dyn. | Lect. | Eff. | Ecr. dyn. | Eff. |
|-----------|------|-----------|------|-------|-----------|-------|------|-----------|------|

C1 ← → C2 ← → C1

## FIG. 8

## écriture / effacement

Cmd / trigger in (60) (31)

| PIV | trig |
| GEN | ch0 |

Grille (G)

| PIV | ch1 |

Drain (D)

| PIV | ch2 |

écriture

0V
0V

7V/10V
0V

71

3V/5V
0V

72

effacement

5V
0V
0V

-17V/-20V

70

0V

0V

**FIG. 7A**

Cmd / trigger in (60) (31)

| PIV | trig |
| GEN | ch0 |

Grille (G)

| PIV | ch1 |

Drain (D)

| PIV | ch2 |

0V
0V

~10V

73

0V

-5V

$t_L$

lecture

**FIG. 7B**

Saisie des paramètres d'endurance — F1

Calcul des chronogrammes PIV / GEN — F2

F3 — Conversion en langage machine PIV / GEN

Chargement dans PIV — F4

Chargement dans GEN — F4'

F5 — Exécution

Extraction et enregistrement des données — F6

**FIG. 9**

FIG. 10A

FIG. 10B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2012124273 A1

**Littérature non-brevet citée dans la description**

- **V. DELLA MARCA et al.** Impact of endurance degradation on the programming efficiency and the energy consumption of NOR flash memories. *Microelectronics Reliability,* 2014, vol. 54, 2262-2265